# EUROPÄISCHE PATENTSCHRIFT

(11) **EP 2 854 489 B1**
(45) Veröffentlichungstag und Bekanntmachung des Hinweises auf die Patenterteilung: **08.11.2017**
(21) Anmeldenummer: 14183847.4
(22) Anmeldetag: 05.09.2014
(51) Int. Cl.: H05K 1/14, H05K 3/00, F21S 4/28, F21V 19/00, F21V 19/04, F21V 7/00, F21Y 115/10, F21Y 103/10

(54) **LED-Leuchte**
LED light
Lampe à DEL

(30) Priorität: 25.09.2013 DE 102013219333
(43) Veröffentlichungstag der Anmeldung: 01.04.2015
(73) Patentinhaber: OSRAM GmbH, 80807 München (DE)
(72) Erfinder: Dellian, Harald, 83564 Soyen (DE); Reingruber, Fabian, 80796 München (DE)

(56) Entgegenhaltungen:
- WO-A2-2012/052722
- WO-A2-2013/066920
- DE-U1-202009 002 978
- KR-B1- 101 082 587
- US-A1- 2003 071 581
- US-A1- 2008 106 892
- US-A1- 2009 046 456
- US-A1- 2010 203 757
- US-A1- 2011 111 632

## Beschreibung

### Technisches Gebiet

Die Erfindung geht aus von LED-Leuchten, die mehrere in Reihe geschaltete Light Emitting Dioden (LEDs) haben.

### Stand der Technik

Aus dem Stand der Technik sind in Reihe geschaltete LEDs bekannt, die untereinander fest verdrahtet sind.
Auf der Internetseite der Firma Relco www.relcogroup.de bzw. deren Tochterunternehmen VLM s.p.a. (www.vlm.it) und im Produktkatalog der selben Firma sind LED-Leuchten offenbart bei denen mehrere LEDs in Reihe geschaltet sind. Die LEDs sind dabei auf einer gemeinsamen Leiterplatte gruppiert und daher nicht einzeln austauschbar.
Darüber hinaus sind beim Einsatz derartiger Leuchten meistens Reflektoren zur Bündelung oder Ausrichtung des von den LEDs abgegebenen Lichts vorgesehen. Diese sind gemäß dem Stand der Technik als von der elektrischen Versorgung unabhängige Teile bekannt. Dokument US2010/0203757 offenbart eine Leuchte gemäß dem Oberbegriff des Anspruchs 1.

### Darstellung der Erfindung

Die Aufgabe der vorliegenden Erfindung ist es, eine LED-Leuchte mit mehreren in Reihe geschalteten LEDs zu schaffen, deren LEDs frei konfiguriert und ausgetauscht werden können.
Diese Aufgabe wird gelöst durch eine LED-Leuchte mit mehreren in Reihe geschalteten LEDs. Zwischen den LEDs angeordnete Stromleiter bilden dabei elastische Halteelemente für die LEDs. Die Halteelemente bilden Reflektorabschnitte.

Besonders vorteilhafte Ausgestaltungen finden sich in den abhängigen Ansprüchen.

Bei einer besonders bevorzugten Weiterbildung sind die LEDs auf einer jeweiligen Leiterplatte angeordnet, wobei jeweils ein Halteelement - vorzugsweise über Lötpads - in elektrischem Kontakt mit zwei zueinander benachbarten Leiterplatten ist und dabei als Halteelement für diese beiden Leiterplatten dient.

Bei einer besonders bevorzugten Weiterbildung sind die Leiterplatten entlang einer Längsachse der LED-Leuchte angeordnet. Die LED-Leuchte hat zwei Reflektorseitenteile, die sich beidseitig der Längsachse im Wesentlichen über die gesamte Leuchte erstrecken. Diese können, obwohl sie einteilig ausgebildet sind, das Licht aller LEDs reflektieren bzw. bündeln bzw. streuen.

Wenn jedes Halteelement bzw. Reflektorabschnitt aus einem quer zur Längsachse gebogenen ursprünglich flächigen Blech gefertigt ist, ergibt sich ein gute Niederhaltfähigkeit bei einfacher Fertigung.

Vorzugsweise ist jedes Halteelement bzw. jeder Reflektorabschnitt im Wesentlichen spiegelsymmetrisch zu einer senkrecht zur Längsachse angeordneten Querebene geformt. Dabei hat jedes Halteelement bzw. jeder Reflektorabschnitt zwei Reflexionsbereiche, die jeweils einer LED zugewandt sind. Dabei liegt ein Randabschnitt jedes Reflexionsbereiches an einer Leiterplatte an.

Vorzugsweise sind die beiden an einer Leiterplatte anliegenden Reflexionsbereiche von der LED weg biegbar, so dass die Leiterplatte aus der erfindungsgemäßen LED-Leuchte entnehmbar ist.

Eine vorrichtungstechnisch einfache Sicherstellung der richtigen Polung beim Einbau oder beim Austauschen der Leitplatten ergibt sich, wenn zwischen jeder Leiterplatte und einem der Reflektorseitenteile eine Positionierhilfe angeordnet ist, die ein Vorsprung sein kann, und die in eine entsprechend geformte seitliche Ausnehmung der Leiterplatte eintaucht.

Eine vorrichtungstechnisch einfache Verbindung zwischen den Halteelementen bzw. Reflektorabschnitten und den Reflektorseitenteilen ergibt sich, wenn die Halteelemente bzw. Reflektorabschnitte jeweils zwei Vorsprünge haben, die sich quer zur Längsachse erstrecken, und die in jeweilige Ausnehmungen der Reflektorseitenteile eingesetzt sind.

Ein einfache Kühlung mit guter Wärmeableitung von den LEDs ergibt sich, wenn die Leiterplatten über zwei Halteelemente bzw. Reflektorabschnitte gegen einen flächigen Kühlkörper vorgespannt sind. Dabei stützen sich die Halteelemente bzw. Reflektorabschnitte über die Vorsprünge in den Ausnehmungen der Reflektorseitenteile ab.

Die Wärmeableitung wird dabei weiter verbessert, wenn zwischen dem Kühlkörper und den Leiterplatten ein flächiges flexibles Wärmeleitelement bzw. "thermal interface material" (tim) angeordnet ist.

Zwischen den beiden Reflexionsbereichen eines Halteelements bzw. Reflektorabschnitts kann jeweils ein Steg angeordnet sein, der zwischen dem Halteelement bzw. Reflektorabschnitt und dem Kühlkörper bzw. dem "thermal interface material" (tim) eingespannt ist.

Dabei können die Stege an einem sich im Wesentlichen entlang der Leuchte erstreckenden Gitterrahmen befestigt sein. Der Gitterrahmen liegt an dem Kühlkörper an, wobei die Leiterplatten jeweils in einer Ausnehmung des Gitterrahmens angeordnet sind.

Es sind auch flächige Anordnungen der LEDs denkbar, indem zum Beispiel mehrere

### Kurze Beschreibung der Zeichnungen

Im Folgenden soll die Erfindung anhand eines Ausführungsbeispiels näher erläutert werden. Die Figuren zeigen:
- Fig. 1: einen Ausschnitt eines Ausführungsbeispiels der erfindungsgemäßen LED-Leuchte in einer perspektivischen Ansicht;
- Fig. 2: einen Ausschnitt des Ausführungsbeispiels gemäß Figur 1 in einem Längsschnitt;
- Fig. 3: einen Ausschnitt des Ausführungsbeispiels gemäß Figur 1 in einem Querschnitt;
- Fig. 4: einen Ausschnitt des Ausführungsbeispiels gemäß Figur 1 in einer Draufsicht; und
- Fig. 5: zwei Ausführungsbeispiele mit erfindungsgemäßen LED-Leuchten mit einer flächigen Anordnung der LEDs.

### Bevorzugte Ausführung der Erfindung

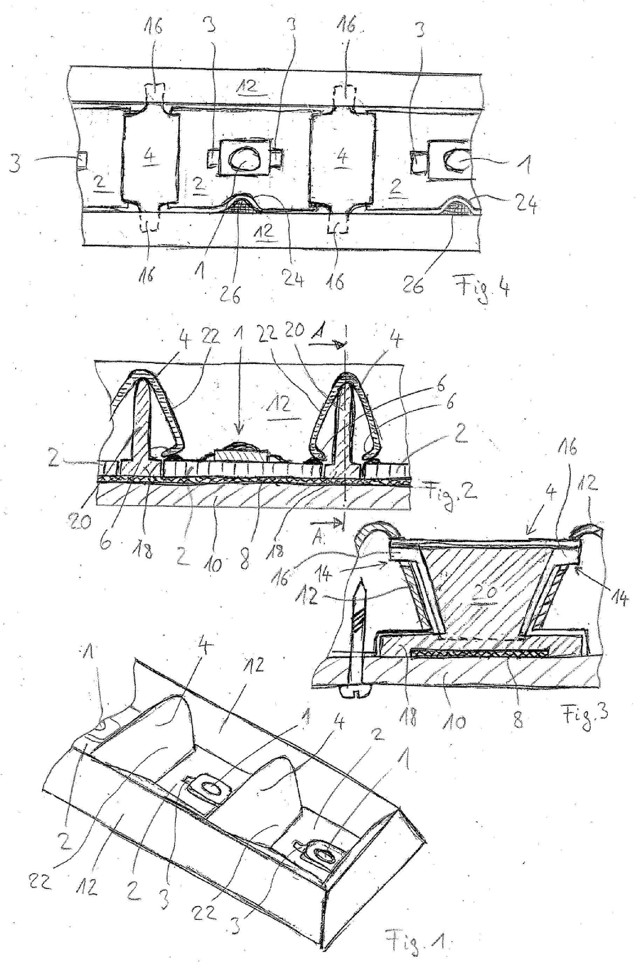

Figur 1 zeigt einen Ausschnitt eines Ausführungsbeispiels einer erfindungsgemäßen LED-Leuchte in einer perspektivischen Ansicht. Sie hat mehrere in einer Reihe angeordnete LEDs, von denen in Figur 1 nur drei LEDs 1 dargestellt sind. Jede LED 1 ist auf einer vergleichsweise kleinen Leiterplatte 2 befestigt. Die LEDs 1 sind jeweils über zwei Lötkontakte 3 elektrisch an die jeweilige Leiterplatte 2 angeschlossen. Die Leiterplatten 2 sind im Wesentlichen rechteckig geformt und in einer Reihe entlang einer (nicht dargestellten) Längsachse der LED-Leuchte zueinander beabstandet angeordnet.

Zwischen zwei benachbarten Leiterplatten 2 ist jeweils ein Halteelement 4 angeordnet.

Figur 2 zeigt einen Ausschnitt des Ausführungsbeispiels gemäß Figur 1 in einem Längsschnitt. Die Halteelemente 4 sind aus Blech gestanzt und gebogen und haben (in dem in Figur 2 gezeigten Schnitt) die Form eines Daches. An den beiden (in Figur 2) unteren Enden eines Halteelements 4 ist jeweils ein Randabschnitt 6 angeordnet. Über jeden Randabschnitt 6 wird über ein Lötpad ein Rand einer Leiterplatte 2 (in Figur 2) nach unten vorgespannt. Im eingebauten Zustand der erfindungsgemäßen LED-Leuchte wird diese Vorspannung meistens nach oben gerichtet sein.

In Figur 2 unterhalb der Leiterplatten 2 sind ein flächiges Wärmeleitelement 8 und darunter ein flächiger Kühlkörper 10 angeordnet, wobei der Kühlkörper 10 auch die Funktion einer Grundplatte der erfindungsgemäßen LED-Leuchte hat. Das Wärmeleitelement 8 ist aus elastischem bzw. kompressiblen "thermal interface material" gebildet und gleicht somit Unebenheiten zwischen den Leiterplatten 2 und dem Kühlkörper 10 aus.

Im Betrieb der erfindungsgemäßen LED-Leuchte wird die Wärme der LEDs 1 über ihre Leiterplatten 2 und über das Wärmeleitelement 8 zum Kühlkörper 10 übertragen und von letzterem an die Umgebung abgegeben.

In Figur 2 ist ersichtlich, dass durch ein manuelles Auseinanderdrücken der beiden an einer Leiterplatte 2 anliegenden Randabschnitte 6 die Leiterplatte 2 mit der LED 1 freigegeben und somit entfernt oder ausgetauscht werden kann. Wenn die beiden Randabschnitte 6 eines einzigen Halteelements 4 zusammengedrückt werden, werden zwei zueinander benachbarte Leiterplatten 2 teilweise freigegeben. Da über die Halteelemente 4 , während sie berührt oder zusammengedrückt werden, Strom fließen kann, wird das gezeigte Ausführungsbeispiel der erfindungsgemäßen LED-Leuchte mit Safety Extra Low Voltage (SELV) betrieben.

Aus Figur 1 ist ersichtlich, dass das Ausführungsbeispiel der erfindungsgemäßen LED-Leuchte eine Reflektoranordnung hat, die zwei Reflektorseitenteile 12 hat, wobei die Halteelemente 4 Reflektorabschnitte der Reflektoranordnung bilden. Die beiden Reflektorseitenteile 12 erstrecken sich beidseitig der Leiterplatten 2 entlang des Ausführungsbeispiels der LED-Leuchte. Durch die Reflektoranordnung wird das von der LED in zwei gegenüberliegende seitliche Richtungen abgestrahlte Licht über die Reflektorseitenteile 12 reflektiert, während das zu den beiden anderen einander gegenüberliegenden Seiten abgestrahlte Licht von Reflexionsbereichen 22 an den Flanken der Halteelemente 4 reflektiert wird.

Figur 3 zeigt einen Ausschnitt des Ausführungsbeispiels gemäß Figur 1 in einem Querschnitt. Dabei ist ersichtlich, dass die beiden Reflektorseitenteile 12 an ihren inneren den LEDs zugewandten Seiten jeweils mehrere Ausnehmungen 14 haben, in die Vorsprünge 16 der Halteelemente 4 eingesetzt sind. Die Vorsprünge 16 erstrecken sich quer zur Längsachse der LED-Leuchte. Somit ist jedes Halteelement 4 über die beiden Vorsprünge 16 in den beiden Reflektorseitenteilen 12 gehalten. Da das in Figur 3 geschnitten dargestellte Halteelement 4 zwei (in Figur 3 nicht gezeigte) Leiterplatten 2 nach unten vorspannt, stützt sich das Halteelement 4 (in Figur 3) nach oben in den beiden Ausnehmungen 14 der beiden Reflektorseitenteile 12 ab.

Die Leiterplatten 2 sind an ihren Außenrändern von einem gemeinsamen Gitterrahmen umfasst, der sich entlang der LED-Leuchte erstreckt. Von dem Gitterrahmen sind in Figur 3 nur ein und in Figur 2 nur zwei Querstreben 18 gezeigt. Die Querstreben 18 erstrecken sich quer zur Längsachse und sind zwischen zwei zueinander benachbarten Leiterplatten 2 angeordnet. Von jeder Querstrebe 18 des Gitterrahmens erstreckt sich ein flächiger Steg 20 (in den Figuren 2 und 3) nach oben. Somit ist im Innern jedes Halteelements 4 ein Steg 20 als Stütze für das Halteelement 4 angeordnet.

Beim gezeigten Ausführungsbeispiel dienen die Halteelemente 4 zum Halten der Leiterplatten 2 in der LED-Leuchte und zum Andrücken der Leiterplatten 2 an das Wärmeleitelement 8 sowie zum Weiterleiten des Stroms von einer Leiterplatte 2 zur nächsten Leiterplatte 2 und weiterhin zum Reflektieren des von der benachbarten LED 1 in ihre Richtung abgegebenen Lichts.

Figur 4 zeigt einen Ausschnitt des Ausführungsbeispiels gemäß Figur 1 in einer Draufsicht. Dabei ist neben den mit Bezug zu den Figuren 1 bis 3 erläuterten Teilen weiterhin in jeder Leiterplatte 2 eine seitliche Ausnehmung 24 dargestellt. In diese Ausnehmung 24 erstreckt sich eine entsprechend geformte Positionierhilfe 26. Dadurch ist sichergestellt, dass jede Leiterplatte 2 beim Einbau bzw. beim Austausch nur mit korrekter Polung zwischen die beiden Reflektorseitenteile 12 und zwischen den beiden Halteelementen 4 eingesetzt werden kann.

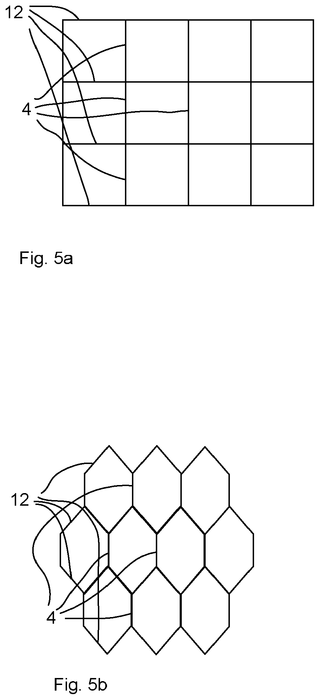

Figur 5 zeigt schematisch zwei Anordnungen, bei denen die LEDs 1 nicht mehr in Reihe sondern in einer flächigen Anordnung angeordnet sind, wobei Fig. 5a eine rechteckige, insbesondere quadratische Anordnung. Diese kann prinzipiell als eine Aneinanderreihung von Anordnungen gemäß der Figuren 1-4 aufgebaut sein, wobei nun beidseits ihrer Längsseiten der Reflektorseitenteile 12 LEDs angeordnet sein können. Auch ein hexagonaler Aufbau, wie in Fig. 5b gezeigt, ist eine mögliche bevorzugte Anordnung, da hierbei eine besonders große Packungsdichte erzielt werden kann und die Lichtverteilung bei Annäherung der die LEDs umgebenden Reflektorelemente an eine Kreis vorteilhaft gestaltet. Die Anordnung der Reflektorseitenwände 12 und der Haltelemente 4 ist dabei beispielsweise dergestalt denkbar, dass die Reflektorseitenwände 12 in Querrichtung der Figur verlaufen, quasi als "Zickzack-Linien" und die zur Hauptlinie A der Zickzack-Linie senkrechten Abschnitte als Haltelemente 4 ausgebildet sind.

## Patentansprüche

1. LED-Leuchte mit mehreren in Reihe geschalteten LEDs (1) wobei zwischen den LEDs (1) angeordnete Stromleiter elastische Halteelemente (4) für die LEDs (1) bilden, **dadurch gekennzeichnet, dass** die Halteelemente (4) Reflektorabschnitte bilden.

2. LED-Leuchte nach Anspruch 1, wobei die LEDs (1) auf einer jeweiligen Leiterplatte (2) angeordnet sind, und wobei jeweils ein Halteelement (4) für zwei Leiterplatten (2) dient und in elektrischem Kontakt mit den beiden Leiterplatten (2) ist.

3. LED-Leuchte nach Anspruch 2, wobei die Leiterplatten (2) entlang einer Längsachse angeordnet sind, und wobei zwei Reflektorseitenteile (12) vorgesehen sind, die sich beidseitig der Längsachse entlang dieser erstrecken.

4. LED-Leuchte nach Anspruch 3, wobei jedes Halteelement (4) aus einem quer zur Längsachse gebogenen Blech gefertigt ist.

5. LED-Leuchte nach Anspruch 3 oder 4, wobei jedes Halteelement (4) spiegelsymmetrisch zu einer senkrecht zur Längsachse angeordneten Querebene (A-A) geformt ist, und wobei jedes Halteelement (4) zwei Reflexionsbereiche (22) hat, die jeweils einer LED (1) zugewandt sind, und wobei ein Randabschnitt (6) jedes Reflexionsbereiches (22) an einer Leiterplatte (2) anliegt.

6. LED-Leuchte nach Anspruch 5, wobei die beiden Reflexionsbereiche (22) von der jeweiligen LED (1) weg biegbar sind, so dass die Leiterplatte (2) entnehmbar ist.

7. LED-Leuchte nach einem der Ansprüche 3 bis 6, wobei zwischen jeder Leiterplatte (2) und einem der Reflektorseitenteile (12) eine Positionierhilfe (26) angeordnet ist, der in eine entsprechend geformte seitliche Ausnehmung (24) der Leiterplatte (2) eintaucht.

8. LED-Leuchte nach einem der Ansprüche 3 bis 7, wobei die Halteelemente (4) jeweils zwei Vorsprünge (16) haben, die sich quer zur Längsachse erstrecken, und die in jeweilige Ausnehmungen (14) der Reflektorseitenteile (12) eingesetzt sind.

9. LED-Leuchte nach Anspruch 8, wobei jede Leiterplatte (2) über zwei Halteelemente (4) gegen einen flächigen Kühlkörper (10) vorgespannt ist, und wobei die Halteelemente (4) über die Vorsprünge (16) in den Ausnehmungen (14) der Reflektorseitenteile (12) abgestützt sind.

10. LED-Leuchte nach Anspruch 5 und 9, wobei zwischen den beiden Reflexionsbereichen (22) eines Halteelements (4) jeweils ein Steg (20) angeordnet ist, der zwischen dem Halteelement (4) und dem Kühlkörper (10) eingespannt ist.

11. LED-Leuchte nach Anspruch 10, wobei die Stege an einem Gitterrahmen befestigt sind, der an dem Kühlkörper anliegt, und wobei die Leiterplatten jeweils in einer Ausnehmung des Gitterrahmens angeordnet sind.

## Claims

1. LED luminaire comprising a plurality of LEDs (1) which are connected in series, wherein current conductors which are arranged between the LEDs (1) form elastic holding elements (4) for the LEDs (1), **characterized in that** the holding elements (4) form reflector sections.

2. LED luminaire according to Claim 1, wherein the LEDs (1) are arranged on a respective printed circuit board (2), and wherein in each case one holding element (4) is used for two printed circuit boards (2) and is in electrical contact with the two printed circuit boards (2).

3. LED luminaire according to Claim 2, wherein the printed circuit boards (2) are arranged along a longitudinal axis, and wherein two reflector side parts (12) are provided which extend along the longitudinal axis on either side of the said longitudinal axis.

4. LED luminaire according to Claim 3, wherein each holding element (4) is produced from a metal sheet which is bent transversely to the longitudinal axis.

5. LED luminaire according to Claim 3 or 4, wherein each holding element (4) is formed with mirror-image symmetry to a transverse plane (A-A) which is arranged perpendicularly to the longitudinal axis, and wherein each holding element (4) has two reflection regions (22) which each face an LED (1), and wherein an edge section (6) of each reflection region (22) bears against a printed circuit board (2).

6. LED luminaire according to Claim 5, wherein the two reflection regions (22) can be bent away from the respective LED (1), so that the printed circuit board (2) can be removed.

7. LED luminaire according to one of Claims 3 to 6, wherein a positioning aid (26) is arranged between each printed circuit board (2) and one of the reflector side parts (12), the said positioning aid entering a correspondingly shaped lateral recess (24) in the printed circuit board (2).

8. LED luminaire according to one of Claims 3 to 7, wherein the holding elements (4) each have two projections (16) which extend transversely to the longitudinal axis and which are inserted into respective recesses (14) in the reflector side parts (12).

9. LED luminaire according to Claim 8, wherein each printed circuit board (2) is prestressed against a flat heat sink (10) by means of two holding elements (4), and wherein the holding elements (4) are supported by means of the projections (16) in the recesses (14) in the reflector side parts (12).

10. LED luminaire according to Claims 5 and 9, wherein a web (20) is arranged between the two reflection regions (22) of a holding element (4) in each case, the said web being clamped between the holding element (4) and the heat sink (10).

11. LED luminaire according to Claim 10, wherein the webs are fastened to a grid frame which bears against the heat sink, and wherein the printed circuit boards are each arranged in a recess in the grid frame.

## Revendications

1. Lampe à DEL comprenant plusieurs DEL (1) connectées en série, des conducteurs disposés entre les DEL (1) formant des éléments de maintien (4) élastiques pour les DEL, **caractérisée en ce que** les éléments de maintien (4) forment des sections de réflecteur.

2. Lampe à DEL selon la revendication 1, les DEL (1) étant disposées sur une plaquette à circuit imprimé (2) respective, et un élément de maintien (4) servant respectivement à deux plaquettes à circuit imprimé (2) et étant en contact électrique avec les deux plaquettes à circuit imprimé (2).

3. Lampe à DEL selon la revendication 2, les plaquettes à circuit imprimé (2) étant disposées le long d'un axe longitudinal, et deux parties latérales de réflecteur (12) étant ménagées, lesquelles s'étendent de chaque côté de l'axe longitudinal, le long de celui-ci.

4. Lampe à DEL selon la revendication 3, chaque élément de maintien (4) étant fabriqué dans une tôle pliée transversalement à l'axe longitudinal.

5. Lampe à DEL selon la revendication 3 ou 4, chaque élément de maintien (4) étant formé avec symétrie de miroir par rapport à un plan transversal (A-A) disposé perpendiculairement à l'axe longitudinal, et chaque élément de maintien (4) ayant deux zones de réflexion (22) qui sont respectivement tournées vers une DEL (1), et une section de bord (6) de chaque zone de réflexion (22) étant adjacente à une plaquette à circuit imprimé (2).

6. Lampe à DEL selon la revendication 5, les deux zones de réflexion (22) pouvant être pliées en s'éloignant de la DEL (1) respective, de sorte que la plaquette à circuit imprimé (2) soit amovible.

7. Lampe à DEL selon l'une quelconque des revendications 3 à 6, une aide de positionnement (26) étant disposée entre chaque plaquette à circuit imprimé (2) et l'une des parties latérales de réflecteur (12), laquelle aide de positionnement plonge dans un évidement latéral (24) de la plaquette à circuit imprimé (2), formé de manière correspondante.

8. Lampe à DEL selon l'une quelconque des revendications 3 à 7, les éléments de maintien (4) ayant respectivement deux saillies (16) qui s'étendent transversalement à l'axe longitudinal et qui sont insérées dans des évidements (14) respectifs des parties latérales de réflexion (12).

9. Lampe à DEL selon la revendication 8, chaque plaquette à circuit imprimé (2) étant précontrainte contre un corps de refroidissement (10) plat par l'intermédiaire de deux éléments de maintien (4), et les éléments de maintien (4) étant soutenus dans les évidements (14) des parties latérales de réflecteur (12) par l'intermédiaire des saillies (16).

10. Lampe à DEL selon les revendications 5 et 9, une nervure (20) étant respectivement disposée entre les deux zones de réflexion (22) d'un élément de maintien (4), laquelle nervure est serrée entre l'élément de maintien (4) et le corps de refroidissement (10).

11. Lampe à DEL selon la revendication 10, les nervures étant fixées sur un cadre en grille qui est adjacent au corps de refroidissement, et les plaquettes à circuit imprimé étant respectivement disposées dans un évidement du cadre en grille.
